# EUROPEAN PATENT APPLICATION

(11) **EP 1 263 061 A2**
(43) Date of publication of application: **04.12.2002**
(21) Application number: 01120626.5
(22) Date of filing: 29.08.2001
(51) Int. Cl.: H01L 51/20

(54) **Electroluminescent film device**

(30) Priority: 29.05.2001 JP 2001161057
(71) Applicant: Hitachi, Ltd., Chiyoda-ku, Tokyo 101-8010 (JP)
(72) Inventor: Nakayama, Takahiro, Hitachi, Ltd., Int. Prop. Gp., Chiyoda-ku, Tokyo 100-8220 (JP); Aratani, Sukekazu, Hitachi, Ltd., Int. Prop. Gp., Chiyoda-ku, Tokyo 100-8220 (JP)
(74) Representative: Beetz & Partner Patentanwälte

(57) **Abstract**

The present invention aims at high-efficient light emission in an organic light emitting device. That is, in the ligth-emitting layer (14) of the organic light-emitting device of the present invention, a spin conversion material (14a) is used as a main material and a light-emitting material (14b) is added separately, whereby an excited state is utilized efficiently.

## Description

### BACKGROUND OF THE INVENTION

The present invention relates to an electroluminescent film device capable of generating photons by utilizing an excited state generated by electron-hole recombination.

In organic electroluminescent devices, a singlet excited state and a triplet excited state are generated at a ratio of 1:3 in a section having a function of excited state generation-photon conversion (the section is hereinafter referred to as a light-emitting layer). However, only the singlet excited state occupying 1/4 of the total excited state could be utilized for light emission (such materials are hereinafter referred to as a singlet-utilizing material, for convenience). In recent years, it has been found out that, in light-emitting molecules each containing a bonded heavy metal (e.g. Ir or Pt), the quantum number of orbital angular momentum and the quantum number of excited state spin are converted into each other by their interaction occurring owing to the effect of the heavy metal and that an excited state of more than 1/4 of the total excited state can be utilized for light emission (such materials are hereinafter referred to as a spin conversion material, for convenience).

The light-emitting layer had a structure using a light-emitting material of single composition, but was low in efficiency owing to the interaction between light-emitting molecules (this interaction is called density extinction). For alleviation of the density extinction, there has been used a structure using a singlet-utilizing material doped with about several % of a spin conversion light-emitting material or a singlet excited state-utilizing light-emitting material, as described in, for example, Blado et al.: Appl. Phys. Lett., Vol. 74, No. 3, p. 442.

In a singlet-utilizing material doped with a spin conversion light-emitting material or a singlet excited state-utilizing light-emitting material, the density extinction can be prevented but the quantum efficiency in electroluminescence has a theoretical limit of 25%.

### DISCLOSURE OF THE INVENTION

The present invention aims at improvement in quantum efficiency (ratio of generated photons to injected electric charges) or energy efficiency (ratio of emitted light energy to applied energy), which improvement has been a common task in various light-emitting devices including light-emitting displays.

In the present invention, the above aim is achieved by using, in a light-emitting layer (where an excited state is generated) of a light-emitting device, a spin conversion material as a main material and separately adding thereto a light-emitting material to efficiently utilize an excited state.

The present invention provides an electroluminescent film device having a light-emitting layer where an excited state generated by electron-hole recombination is utilized for photon generation, in which device the light-emitting layer contains;
a material in which the quantum number of orbital angular momentum and the quantum number of excited state spin are convertible into each other by their interaction, and
a light-emitting molecule mixed into the above material.

In this electroluminescent film device, a recombination excited state is generated by using a material in which the quantum number of orbital angular momentum and the quantum number of excited state spin are convertible into each other by their interaction; the resulting excited energy is transferred to a light-emitting molecule; thereby, light emission is allowed to take place.

The present invention also provides an electroluminescent film device having a light-emitting layer where an excited state generated by electron-hole recombination is utilized for photon generation, in which device the light-emitting layer is an organic film formed by simultaneous vapor deposition, containing:
a material in which the quantum number of orbital angular momentum and the quantum number of excited state spin are convertible into each other by their interaction, and
a light-emitting molecule, each as an independent dopant.

The material in which the quantum number of orbital angular momentum and the quantum number of excited state spin are convertible into each other by their interaction, can be a molecule in which a heavy metal atom (a metal atom having an atomic number of 76 or more) is bonded to or coordinated to an organic material; and the heavy metal atom can be Ir or Pt.

The light-emitting molecule can be a molecule in which a heavy metal atom (a metal atom having an atomic number of 76 or more) is bonded to or coordinated to an organic material; and the heavy metal atom can be Ir or Pt.

According to the present invention, a triplet excited state can be utilized for light emission similarly to a singlet excited state, whereby an improved quantum efficiency can be obtained.

### BRIEF DESCRIPTION OF THE DRAWINGS

Fig. 1 is a schematic sectional view showing an example of the organic light-emitting device of the present invention using a spin conversion material as a main component of the light-emitting layer.
Fig. 2 shows the structures of organic molecules.
Fig. 3 is a graph showing the emission spectrum of an organic light-emitting device having a light-emitting layer in which PtOEP is mixed into Ir(ppy)₃.
Fig. 4 is a schematic sectional view showing another example of the organic light-emitting device of the present invention.
Fig. 5(a) is a graph showing the emission spectrum of an organic light-emitting device having a light-emitting layer in which Ir(ppy)₃ is mixed into CBP; Fig. 5(b) is a graph showing the emission spectrum of an organic light-emitting device having a light-emitting layer in which PtOEP is mixed into CBP; and Fig. 5(c) is a graph showing the emission spectrum of an organic light-emitting device having a light-emitting layer in which PtOEP is mixed into Ir(ppy)₃.
Fig. 6 is a schematic sectional view of an organic light-emitting device having a light-emitting layer in which a spin conversion material and a light-emitting material are mixed into a singlet-utilizing material.
Fig. 7 is a schematic sectional view showing an example of a multi-component vapor deposition apparatus.

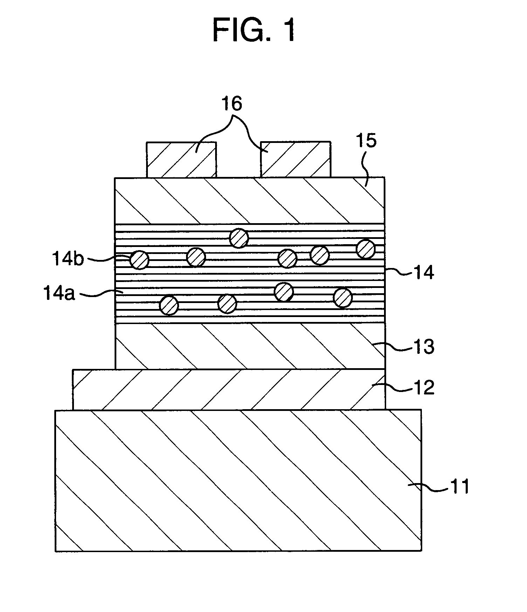

The numerals used in Fig. 1, Fig. 6 and Fig. 7 refer to the followings.

11: transparent substrate, 12: transparent electrode, 13: hole transport layer, 14: light-emitting layer, 15: electron transport layer, 16: metal electrode, 14a: spin conversion material, 14b: light-emitting molecule, 24: light-emitting layer, 24a: singlet-utilizing material, 31:chamber, 32: vacuum-discharging system, 33: substrate, 34 to 36: vapor deposition boats, 37 to 39: heating electrodes

### BEST MODE FOR CARRYING OUT THE INVENTION

The embodiments of the present invention are described below with referring to the accompanying drawings.

Fig. 1 is a schematic sectional view showing an example of the organic light-emitting device of the present invention using a spin conversion material as a main component of the light-emitting layer. This light-emitting device is a kind of pin type light-emitting diode, wherein a transparent electrode 12, a hole transport layer 13, a light-emitting layer 14, an electron transport layer 15 and a metal electrode 16 are formed on a transparent substrate 11. In the light-emitting layer 14, the holes injected from the electrode 12 combine with the electrons injected form the electrode 16, to generate an excited state. The light-emitting layer 14 is constituted by using a spin conversion material as a main component 14a and mixing thereinto a light-emitting molecule 14b in such a concentration (about 0.1 to 20% by volume) as to cause no density extinction. The spin of excited state in the light-emitting layer is convertible between singlet state and triplet state owing to the presence of the spin conversion material (the main component) 14a; the singlet excited state transfers to the light-emitting molecule 14b; thereby, light emission takes place. Consequently, more than 1/4 of the total excited state is utilized for light emission. This advantageous phenomenon occurs not only when the light-emitting material mixed into the main component is a singlet-utilizing material but also when it is a spin conversion material. It is appropriate that the spin conversion material constituting the main component of the light emission layer has an energy band gap larger than the light-emitting energy of the light-emitting molecule, and the spin conversion material per se may have a light-emitting property or no light-emitting property. In general, the light-emitting molecule can exhibit a high efficiency in the case of having an energy band gap width larger than a triplet excited state-converted molecule has.

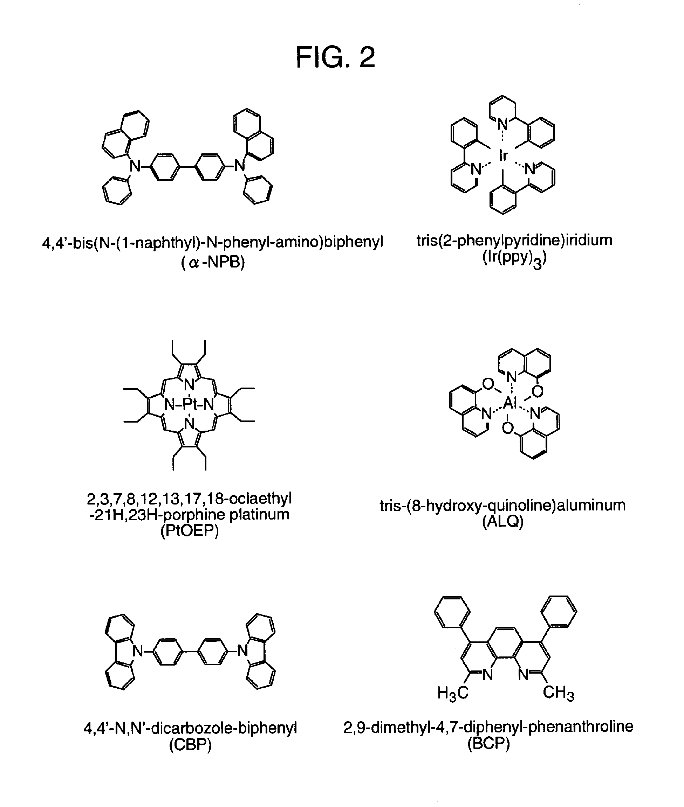

An organic light-emitting device shown by the schematic sectional view of Fig. 1 was produced. On a glass substrate 11 were formed, in the following order, a transparent electrode 12 [made of ITO (indium titanium oxide)] in 200 nm, a hole injection layer 13 (made of α-NPB) in 35 nm, a light-emitting layer 14 [6% by volume of PtOEP (14b) is mixed into Ir(ppy)₃ (14a)] in 20 nm, and an electron transport layer 15 (made of AlQ) in 22 nm. Thereon were formed, as an upper electrode 16, a LiF layer in 0.5 nm and an Al layer in 150 nm in this order. In the above layer or electrode formation, ITO is formed typically by sputtering and other layers are formed typically by vapor deposition of boat heating type. In Fig. 2 are shown the structures of the organic molecules used. By applying a DC voltage of +4 V or more to the above-produced device between the ITO electrode 12 and the Al layer 16, light emission of PtOEP can be obtained at a high efficiency.

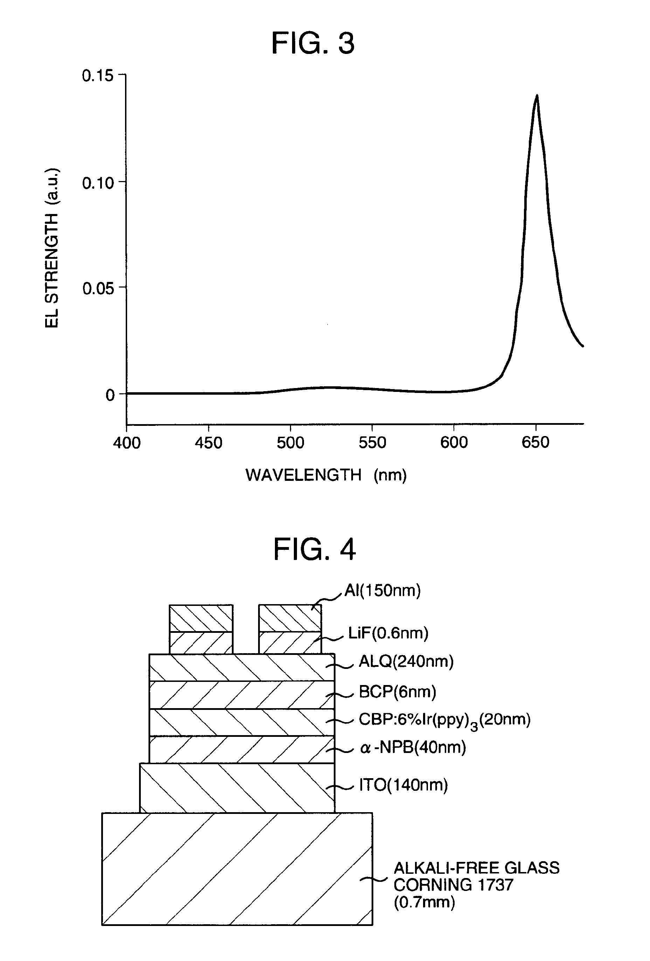

In Fig. 3 is shown the emission spectrum of the organic light-emitting device produced above. Ir(ppy)₃ is also a light-emitting molecule and its emission spectrum has a peak at around 520 nm. In Fig. 3, however, substantially no emission spectrum of Ir(ppy)₃ is seen and an intense peak of PtOEP is observed at 650 nm.

The wavelength of the light emitted by a light-emitting device can be varied by changing the material of the light-emitting layer. Fig. 4 is a schematic sectional view showing another example of the organic light-emitting device of the present invention having a light-emitting layer in which Ir(ppy)₃ as a light-emitting molecule is mixed into CBP (a spin conversion material) as a main component. On an alkali-free glass were formed, in the following order, an ITO transparent electrode in 140 nm, a hole-injecting layer (made of α-NPB) in 40 nm, a light-emitting layer [6% by volume of Ir(ppy)₃ is mixed into CBP] in 20 nm, a buffer layer (made of BCP) in 6 nm, an electron transport layer (made of AlQ) in 240 nm and, as an upper electrode, a LiF layer in 0.6 nm and an Al layer in 150 nm. In the above layer or electrode formation, ITO is formed typically by sputtering and other layers are formed typically by vapor deposition of boat heating type.

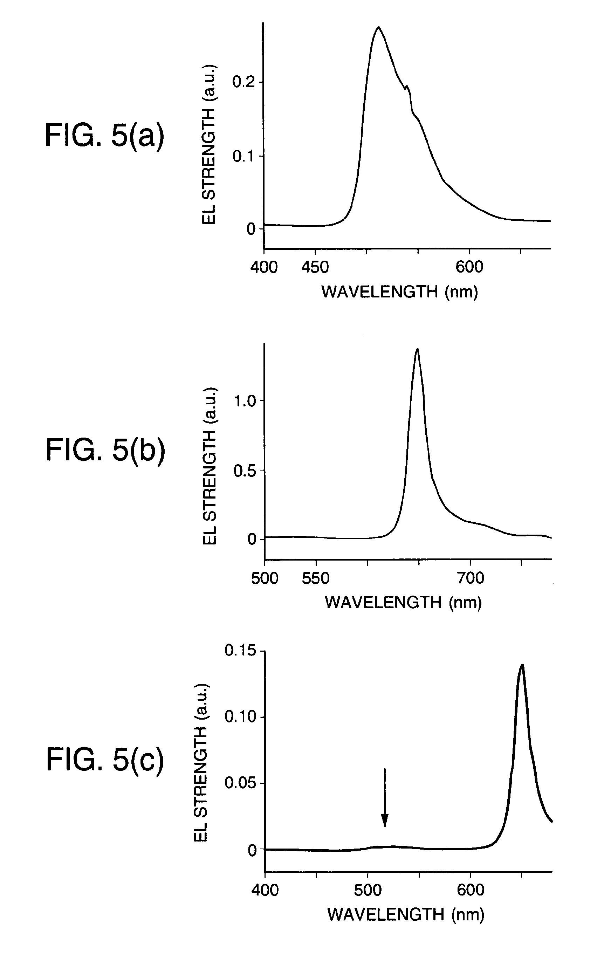

Fig. 5(a) shows the emission spectrum of the light-emitting device shown in Fig. 4. As seen therein, there is a peak of Ir(ppy)₃ at around 520 nm.

There was produced an organic light-emitting device having the same layer structure as shown in Fig. 4 except that the light-emitting layer was constituted by using CBP (a spin conversion material) as a main component and mixing thereinto 6% by volume of PtOEP as a light-emitting molecule. The emission spectrum of the thus-produced device is shown in Fig. 5(b). This emission spectrum has a peak of PtOEP at around 650 nm.

There was produced an organic light-emitting device having the same layer structure as shown in Fig. 4 except that the light-emitting layer was constituted by using Ir(ppy)₃ (a spin conversion material) as a main component and mixing thereinto 6% by volume of PtOEP as a light-emitting molecule. The emission spectrum of the thus-produced device is shown in Fig. 5(c). This emission spectrum has a peak of PtOEP at around 650 nm but shows no peak of Ir(ppy)3 at 520 nm.

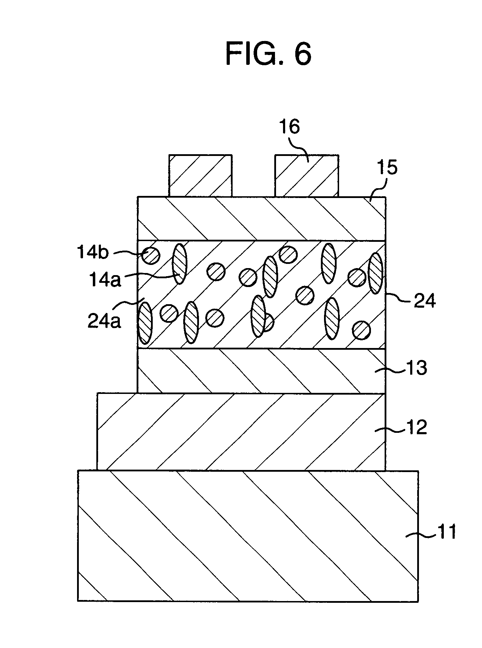

Fig. 6 is a schematic sectional view showing still another example of the organic light-emitting device of the present invention. In Fig. 6, the same numerals as in Fig. 1 are given to the same constituents as in Fig. 1; therefore, no explanation is repeated to such numerals.

When a recombination excited state can move freely in the light-emitting layer 24, all the matrix material in the light-emitting layer need not be a spin conversion material, and an improved efficiency can be obtained in a structure in which a spin conversion material and a light-emitting material are mixed into a singlet-utilizing material. The light-emitting layer 24 (thickness: 20 nm) of the organic light-emitting device shown in Fig. 6 is a film in which 20% by volume of a spin conversion material [Ir(ppy)₃] 14a and 7% by volume of a light-emitting material (PtOEP) 14b are mixed into a main component, i.e. a singlet-utilizing material (CBP) 24a. A structure in which a recombination excited state can move freely in a light-emitting layer, can be obtained by vacuum-depositing organic molecules simultaneously and forming a sufficiently mixed and dispersed state.

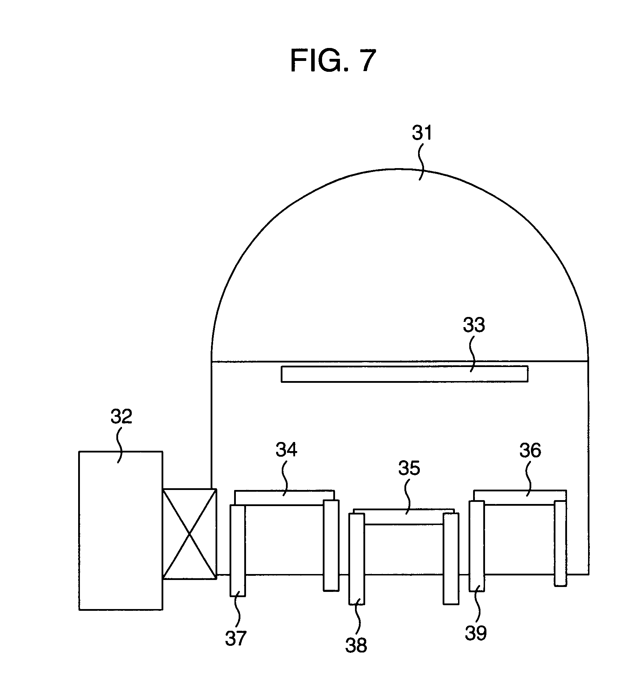

Fig. 7 is a schematic sectional view showing an example of the multi-component vapor deposition apparatus used for forming a light-emitting layer 24. Vapor deposition boats 34, 35 and 36 each containing a material to be vapor-deposited are placed in a chamber 31 which is connected to a vacuum-discharging system 32 to have a vacuum of 10⁻⁶ Torr or higher; above the vapor deposition boats is fixed a substrate 33 with the to-be-deposited surface of the substrate being directed to the vapor deposition boats; the vapor deposition boats 34, 35 and 36 are electrified via heating electrodes 37, 38 and 39 and heated, whereby the materials in the vapor deposition boats are vaporized and vapor-deposited on the substrate 33. The composition of the simultaneous vapor deposition film formed on the substrate can be adjusted by controlling the current passed to the vapor deposition boats.

In the organic light-emitting device shown in Fig. 6, there was used, as the light-emitting layer, a film formed by simultaneous vapor deposition of three components. There can also be used a film formed by simultaneous vapor deposition of four components or more. In that case, the following materials are used in addition to the main component, the spin conversion material and the light-emitting material.

### (1) Spin conversion material of different molecule

Recombination excitons are presumed to have various energy levels. The title material is added when two or more kinds of spin conversion materials are used in order to achieve the conversion of triplet excited states of various energy levels.

### (2) Light-emitting material of different molecule

This material is added when two or more kinds of light-emitting materials are used in order to control the hue of emission spectrum or widen the wavelength range of emission spectrum.

### (3) Other materials

These materials are added when there are used a material for improving the mixability among film materials, the adhesion of light-emitting layer to upper or lower film, etc., and a material (e.g. a Libonded molecule) for improving the electroconductivity of main component material.

With the organic light-emitting device of the present invention described above, the high efficiency brought about by a triplet material can be utilized without being adversely affected by density extinction.

## Claims

1. An electroluminescent film device having a light-emitting layer (14) where an excited state generated by electron-hole recombination is utilized for photon generation, in which device the light-emitting layer (14) contains:
a material (14a) in which the quantum number of orbital angular momentum and the quantum number of excited state spin are convertible into each other by their interaction, and
a light-emitting molecule (14b) mixed into the above material (14a).

2. An electroluminescent film device having a light-emitting layer (14) where an excited state generated by electron-hole recombination is utilized for photon generation, in which device the light-emitting layer (14) is an organic film formed by simultaneous vapor deposition, containing:
a material (14a) in which the quantum number of orbital angular momentum and the quantum number of excited state spin are convertible into each other by their interaction, and
a light-emitting molecule (14b), each as an independent dopant.

3. An electroluminescent film device according to Claim 1 or 2, wherein the material (14a) in which the quantum number of orbital angular momentum and the quantum number of excited state spin are convertible into each other by their interaction, is a molecule in which a heavy metal atom is bonded to or coordinated to an organic material.

4. An electroluminescent film device according to Claim 1 or 2, wherein the light-emitting molecule is a molecule in which a heavy metal atom is bonded to or coordinated to an organic material.

5. An electroluminescent film device according to one of the preceding claims, wherein the heavy metal atom is Ir or Pt.
